# EUROPÄISCHE PATENTSCHRIFT

(11) **EP 0 756 022 B1**
(45) Veröffentlichungstag und Bekanntmachung des Hinweises auf die Patenterteilung: **04.10.2001**
(21) Anmeldenummer: 96108225.2
(22) Anmeldetag: 23.05.1996
(51) Int. Cl.: C23C 28/02, C23C 14/16, C23C 14/58, C23C 2/06, C25D 3/22

(54) **Korrosionsgeschütztes Stahlfeinblech und Verfahren zu seiner Herstellung**
Steel sheet protected against corrosion and process for its production
Tôle d'acier protégée contre la corrosion et procédé pour sa production

(30) Priorität: 27.07.1995 DE 19527515
(43) Veröffentlichungstag der Anmeldung: 29.01.1997
(73) Patentinhaber: FRAUNHOFER-GESELLSCHAFT ZUR FÖRDERUNG DER ANGEWANDTEN FORSCHUNG E.V., 80636 München (DE); PREUSSAG STAHL AG, 31226 Peine (DE); Stahlwerke Bremen GmbH, 28237 Bremen (DE); Thyssen Krupp Stahl AG, 40211 Düsseldorf (DE); VOEST-ALPINE Stahl Linz GmbH, 4020 Linz (AT)
(72) Erfinder: Goedicke, Klaus, 01307 Dresden (DE); Metzner, Christoph, 01324 Dresden (DE); Berner, Klaus, Dr.-Ing., 38228 Salzgitter (DE); Ehlers, Klaus-Dieter, 38268 Lengede (DE); Steinhoff, Hartmut, Dr., 28790 Schwanewede (DE); Dürr, Wilhelm, Dr., 56437 Dinslaken (DE); Schuhmacher, Bernd, Dr., 44227 Dortmund (DE)

(56) Entgegenhaltungen:
- EP-A- 0 576 348
- DE-A- 1 966 807
- LU-A- 86 738

## Beschreibung

Die Erfindung betrifft ein korrosionsgeschütztes Stahlfeinblech auf der Basis eines vorveredelten Stahlfeinbleches und ein Verfahren zu dessen Herstellung. Das Stahlfeinblech findet in vielfältiger Weise in der Bau-, Haushaltgeräte- und Automobilindustrie sowie in anderen Industriezweigen Anwendung.

Es sind korrosionsgeschützte Stahlfeinbleche auf der Basis von Stahlfeinblechen bekannt, die vorzugsweise einen Überzug aus Zink oder Zinklegierungen tragen, der durch Schmelztauchveredelung, elektrolytisches Abscheiden oder andere Verfahren aufgebracht wird. Durch die kathodische Schutzwirkung der zinkhaltigen Schicht und durch ihre Barrierewirkung mit der Bildung einer Deckschicht wird ein guter Korrosionsschutz des Stahlfeinbleches erreicht. Diese verzinkten Stahlfeinbleche werden durch Umformen, Fügen, organische Beschichtung (z. B. Lackieren) oder auf andere Weise zu Gebrauchsgegenständen weiterverarbeitet. Daraus ergeben sich neben der Forderung nach hohem Korrosionsschutz zahlreiche weitere Anforderungen an die Gebrauchs- und Verarbeitungseigenschaften der Stahlfeinbleche. So sind Wirtschaftlichkeit und Umweltverträglichkeit des Herstellungsprozesses, Oberflächenqualität, Umformverhalten, Punktschweißeignung, Phosphatierbarkeit, kataphoretische Lackierbarkeit, Lackhaftung und Korrosionsschutz im unlackierten und lackierten Zustand entscheidende Qualitätsmerkmale korrosionsgeschützter Stahlfeinbleche. Diese Forderungen werden jedoch von den heute verfügbaren Produkten nicht alle gleichzeitig und auf umfassende Weise erfüllt.

Im folgenden werden Vor- und Nachteile der nach den verschiedenen Verfahren verzinkten und mit Zinklegierungsüberzügen vorveredelten Stahlfeinbleche beschrieben, wobei zu berücksichtigen ist, daß die Gewichtung der einzelnen Produkteigenschaften für die unterschiedlichen Verbraucher durchaus verschieden sein kann. Dies wird am Beispiel der Automobilindustire besonders deutlich, wo die einzelnen Fahrzeughersteller unterschiedliche Konzepte im Hinblick auf die Art und Menge des Einsatzes vorveredelter Stahlfeinbleche für die Karosserie verfolgen.

Feuerverzinkte Stahlfeinbleche (Z) zeichnen sich zwar durch einen hohen Korrosionsschutz im unlackierten wie lackierten Zustand aus und können kostengünstig und mit umweltschonenden Verfahren hergestellt werden, sie erreichen jedoch nach dem Umformen nicht die Oberflächenqualität des unveredelten Stahlfeinbleches. Bezüglich der Punktschweißbarkeit wird nicht die hohe Elektrodenstandmenge wie bei unveredelten Feinblechen erreicht. Auch die Phosphatierbarkeit, die KT-Lackierbarkeit und die Lackhaftung von feuerverzinkten Stahlfeinblechen kann nicht als optimal angesehen werden.

Elektrolytisch verzinkte Stahlfeinbleche (ZE) weisen gegenüber feuerverzinkten Stahlfeinblechen (Z) eine bessere Oberflächenqualität und eine verbesserte Phosphatierbarkeit auf. Die anderen genannten Nachteile von Z-Blechen lassen sich für ZE-Bleche nicht vermeiden. Hinzu kommt, daß das Herstellungsverfahren durch höheren Energieeinsatz und die erforderlichen Entsorgungsmaßnahmen, die der naßchemische Elektrolyseprozeß nach sich zieht, kostenintensiver und weniger umweltfreundlich ist.

Um die Mängel von Überzügen aus reinem Zink hinsichtlich der Gebrauchs- und Verarbeitungseigenschaften im Vergleich zu unveredelten Stahlfeinblechen auszugleichen, werden zunehmend Überzüge aus Zinklegierungen verwendet. Ausführungsvarianten sind Galvannealed-Feinblech (ZF), dessen Überzug ca. 10 mass.% Eisen enthält, sowie Zink-Nickel veredeltes Feinblech (ZN), dessen Überzug ca. 10...12 mass.% Nickel enthält.

Galvannealed-Feinblech (ZF) wird durch eine Diffusionsglühung unmittelbar nach dem Schmelztauchverzinken (Feuerverzinken) erzeugt. Es wird eine sehr gute Oberflächenqualität sowie im Vergleich zu Z- und ZE-Blechen eine deutlich günstigere Lackhaftung und Korrosionsbeständigkeit im lackierten Zustand erreicht. Auch die Elekrodenstandmenge übertrifft diejenige von Z- und ZE-Blechen deutlich.

Zink-Nickel veredeltes Stahlfeinblech (ZN) wird durch elektrolytische Abscheidung -der Zinklegierung auf Stahlband hergestellt und zeichnet sich durch hohe Korrosionsbeständigkeit bereits im unlackiertem Zustand und gute Punktschweißeignung aus.

Beide vorveredelten Stahlfeinbleche, ZF und ZN, erfüllen nicht alle Anforderungen, die an die Umformbarkeit gestellt werden. Der Grund dafür ist, daß die Zinklegierungsüberzüge aus intermetallischen Phasen bestehen und deshalb erheblich spröder als Überzüge aus reinem Zink sind. Beim Umformen treten deshalb Mikrorisse und ein weit höherer Abrieb als beim Umformen von Stahlfeinblechen mit Überzügen aus reinem Zink auf. Damit ist auch ein erhöhter Verschleiß der Umformwerkzeuge verbunden. Die Auswahl der verfügbaren Zinklegierungen ist verfahrensbedingt stark eingeschränkt. Außerdem stellt die Entsorgung nickelhaltiger Abwässer bei der Herstellung von ZN-Überzügen eine nicht unerhebliche Kostenbelastung dar.

Aus dem Vorgenannten geht hervor, daß alle technisch eingeführten korrosionsgeschützten Stahlfeinbleche bestimmte Mängel bei einzelnen Gebrauchs- und Verarbeitungseigenschaften aufweisen. Schlußfolgernd daraus versucht die Fachwelt, diese Mängel zu beseitigen und eine optimale Lösung zu finden. Die Versuche gehen dahin, neue Überzuge für korrosionsgeschützte Stahlfeinbleche und verbesserte oder neue Verfahren zu ihrer Herstellung zu finden:

So ist es bekannt, eine verbesserte Steuerung des Galvannealed-Prozesses durchzuführen, wobei der Zinküberzug durch Aufdampfen im Vakuum hergestellt wird (JP 60-67690; JP 62-128168; JP 62-167870).

Es ist weiterhin bekannt, auf galvanisch abgeschiedenem Zink eine Eisenschicht galvanisch abzuscheiden, um die Punktschweißeignung zu verbessern (DE 19 34 081).

Es ist auch bekannt, eine zinkreiche FeZn-Legierung mit 10...20 mass% Eisen abzuscheiden und danach eine Schicht aus reinem Eisen durch lonenplattieren aufzubringen, so daß eine eisenreiche Legierungsschicht oder eine Oberflächenschicht aus reinem Eisen entsteht (JP 63-18067).

Es ist weiterhin bekannt, eine Eisenschicht als Deckschicht auf einen Zinküberzug aufzubringen, um die Schweißbarkeit zu verbessern (DE 19 66 807). Solche Überzüge sind gleichmäßig und bewirken gute Lackierbarkeit und Phosphatierbarkeit. Infolge des hohen Eisengehaltes des Überzuges tritt jedoch unzureichende Korrosionsbeständigkeit auf. Es bildet sich sogenannter Rotrost.

Weiterhin ist es bekannt, eisenreiche Fe-Zn-Legierungen ggfs. mit Zusatzelementen sowie weitere Deckschichten aus Zn und/oder ZnAI-Legierungen aufzubringen (JP 56-133488). Aus Kostengründen werden jedoch solche Schichtsysteme nicht angewendet.

Es sind weiterhin eine Reihe von Schichten für korrosionsgeschützte Stahlfeinbleche bekannt, die darauf beruhen, daß die Korrosionsschutzschichten aus Zink durch Hochvakuumbedampfung aufgebracht sind (JP 60-56062; JP 59-83765).

Schließlich ist eine Vielzahl von Schichtsystemen bekannt, die Zink und ein weiteres, durch Hochvakuumbedampfung aufgebrachtes Metall enthalten. So werden Schichten beschrieben aus Zn mit Fe (JP 1-142076; JP 1-129962), Zn mit Mn (JP 1-42572; DE **44** 38 608 A 1), Zn mit Mg (JP 1-17853), Zn mit Al (JP 1-21055; DD 266 370) und weiteren Schichten (JP 1-52059), Zn mit Mg und Fe (JP 2-305975).

Alle vorgenannten Überzüge zur Herstellung korrosionsgeschützter Stahlfeinbleche, die vollständig durch Hochvakuumbedampfung hergestellt werden, haben bisher keinen oder nur sehr eingeschränkten technischen Einsatz gefunden. Offensichtlich ist ihre Herstellung mit zu hohen Kosten verbunden. Weiterhin bestehen diese Schichten überwiegend aus Zinklegierungen relativ geringer Duktilität, so daß der oben genannte hohe Abrieb beim Umformen durch solche Korrosionsschutzschichten nicht beseitigt werden kann.

Der Erfindung liegt die Aufgabe zugrunde, ein korrosionsgeschütztes Stahlfeinblech und ein Verfahren zu seiner Herstellung zu schaffen, welches die Vorteile von reinen Zinküberzügen auf Stahlfeinblechen, das sind große kathodische Schutzwirkung, hohe Duktilität und vergleichsweise geringer Abrieb bei Umformung sowie einfache, kostengünstige Herstellbarkeit, mit denen von Überzügen aus Zinklegierungen, vor allem gute Punktschweißeignung und gute Phosphatierbarkeit sowie gute Lackhaftung und hoher Korrosionsschutz im lackierten Zustand in sich vereinigt. Das Verfahren soll hohe Flexibilität in bezug auf die Werkstoffauswahl und eine hohe Beschichtungsrate aufweisen und bei seiner Durchführung keine Umweltbelastung hervorrufen.

Die Aufgabe, ein korrosionsgeschütztes Stahlfeinblech zu schaffen, wird mit den Merkmalen des Anspruches 1 gelöst. Das Verfahren zur Herstellung des korrosionsgeschützten Stahlfeinbleches wird nach den Merkmalen des Anspruches 5 gelöst. Vorteilhafte Ausgestaltungen des Stahlfeinbleches und des Verfahrens sind in den Ansprüchen 2 bis 4 bzw. 6 bis 10 beschrieben.

Das erfindungsgemäß korrosionsgeschützte Stahlfeinblech basiert auf der Weiterveredelung von Stahlfeinblechen, die in bekannter Weise nach einem technisch ausgereiften und bewährten Verfahren mit einem Überzug aus Zink oder einer hoch zinkhaltigen Legierung veredelt sind. Die Weiterveredelung wird durch eine Deckschicht erreicht, welche durch einen gesteuerten Diffusions- und Phasenbildungsprozeß in einem begrenzten oberen, dem Stahlfeinblech abgewandten Bereich der Zinkschicht herbeigeführt wird. In dieser Hinsicht unterscheidet sich das erfindungsgemäße Stahlfeinblech grundsätzlich von Galvannealed-Produkten, bei denen der Diffusionsprozeß an der Grenzfläche zwischen Stahl und Zinküberzug einsetzt und bis zur äußeren Oberfläche des Überzuges fortschreitet.

Entgegen dem Stand der Technik besteht diese Deckschicht aus einer zinkreichen Legierung, wodurch eine Bildung von Rotrost auf der Oberfläche ausgeschlossen ist. In nicht erwarteter Weise bilden sich aufgrund des Herstellungsprozesses zinkreiche Mischphasen mit einem oder mehreren der Metalle Eisen, Mangan, Kupfer, Magnesium, Nickel aus, welche eine hohe, gleichmäßige Oberflächenqualität, gute Phospatierbarkeit, gute Lackhaftung, gute Schweißbarkeit bei hoher Standzeit der Elektroden und hohen Korrosionsschutz, insbesondere eine ähnlich gute Lackhaftung und Korrosionsbeständigkeit im lackierten Zustand wie z.B. ZF-Bleche, sicherstellen. Die im Vergleich zur Zinkschicht geringe Dicke der Deckschicht und deren Bildung durch einen gesteuerten Diffusionsvorgang sichern eine hohe Duktilität des Überzuges. Darauf beruht der in zahlreichen Versuchen nachgewiesene sehr geringe Abrieb von Überzugsmaterial beim Umformen. Hervorzuheben ist weiterhin die geringe Dicke des die Deckschicht bildenden Metalls bzw. der Metalle oder der Metallegierung. Weist die Deckschicht beispielsweise eine Dicke von 1 um bei einem Zinkgehalt von 90 mass% auf, so wird diese Schicht mit einer mittleren Schichtdicke von nur 0,1 µm im Vakuum abgeschieden und dann dem gesteuerten Diffusionsprozeß unterworfen. Zum Aufbringen dieser Metallschicht ist das Elektronenstrahl-Hochratebedampfen, vorzugsweise mit Elektronenkanonen vom Axialtyp, besonders geeignet. Infolge der hohen Beschichtungsrate und der geringen Dicke der Schicht kann eine Geschwindigkeit beim Durchlauf des Stahlfeinbleches durch die Vakuumbeschichtungsanlage von über 200 Meter je Minute, wie sie in modernen kontinuierlichen Stahlbandveredelungsanlagen erforderlich ist, erreicht werden. Wegen der geringen Dicke der Metallschicht kann die Vakuumbeschichtung jedoch in bestimmten Fällen auch vorteilhaft durch Magnetron-Zerstäubung erfolgen.

Um den gesteuerten Diffusionsprozeß vorzubereiten und eine hohe Gleichmäßigkeit der Deckschicht zu erzielen, ist es vorteilhaft, das Stahlfeinblech vor der Vakuumbeschichtung einer Vakuumvorbehandlung durch lönenbombardement bzw. einer Plasmabehandlung zu unterwerfen. Zweckmäßigerweise wird das Stahlfeinblech vor der Vakuumbeschichtung erwärmt, vorzugsweise auf 220 °C. Erfindungsgemäß erfolgt die Wärmebehandlung zur Durchführung des gesteuerten Diffusions- und Phasenbildungsprozesses ohne Exposition an oxidierender Atmosphäre. Als geeignet hat sich eine Kurzzeitwärmebehandlung in unmittelbarem Anschluß an die Vakuumbeschichtung über einen Zeitraum von 10 Sekunden im Temperaturbereich zwischen 300 °C und 400 °C bei einem Inertgasdruck von 80 kPa erwiesen, um eine gleichmäßige Deckschicht auszubilden.

An einem Ausführungsbeispiel wird die Erfindung näher erläutert. Dabei zeigen schematisch im Schnitt:
Fig. 1: ein mit einem Zinküberzug versehenes Stahlfeinblech,
Fig. 2: ein Zwischenprodukt nach der Vakuumbeschichtung,
Fig. 3: ein korrosionsgeschütztes Stahlfeinblech als Endprodukt.

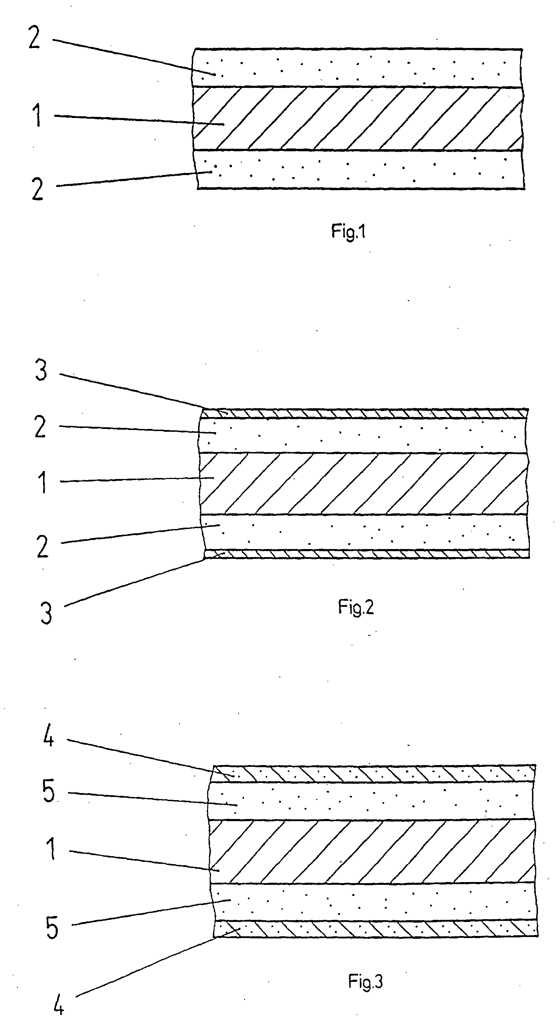

In Fig. 1 ist ein kohlenstoffarmes Stahlfeinblech 1 in bekannter Weise durch Schmelztauchveredelung (Feuerverzinkung) beidseitig mit einem Zinküberzug 2 mit einer Dicke von 15 µm versehen. Zur Weiterveredelung wird dieses Stahlfeinblech 1 entfettet, gereinigt und über Vakuumschleusen in eine Elektronenstrahl-Bandbedampfungsanlage, bestehend aus mehreren Prozeßkammern, eingebracht. Die Anlage ist auf < 1 x 10⁻⁴ mbar evakuiert. In einem ersten Verfahrensschritt in der ersten Prozeßkammer wird das verzinkte, gereinigte Stahlfeinblech durch Wärmestrahlung auf 220 °C geheizt und in einer Plasmakammer einem lonenbombardement ausgesetzt (plasmageätzt). Dazu wirkt eine Argon-Niederdruck-Gasentladung mit einer Leistungsdichte von 1,8 Wcm⁻² in einer Einwirkzeit von 1,5 Sekunden beidseitig auf das verzinkte Stahlfeinblech 1. In einer folgenden Prozeßkammer, der Beschichtungskammer, wird mit je einer zeitlichörtlich programmiert abgelenkten Elektronenkanone vom Axialtyp auf beiden Seiten des verzinkten Stahlfeinbleches eine gleichmäßige 0,1 µm dicke Schicht 3 aus reinem Eisen abgeschieden (Fig. 2). In einer weiteren Prozeßkammer durchläuft das Stahlfeinblech 1 eine Wärmebehandlungsstrecke bei einer gleichmäßigen, konstant gehaltenen Temperatur von (365 ± 5) °C. Entsprechend der eingestellten Bandgeschwindigkeit des Stahlfeinbleches 1 und der Länge der Wärmebehandlungsstrecke beträgt die Zeitdauer für die Wärmebehandlung 4 Sekunden, In dieser Prozeßkammer ist ein Stickstoffdruck von 80 kPa eingestellt. Nach einer Abkühlstrecke tritt das abschließend veredelte Stahlfeinblech 1 über Vakuumschleusen aus der Anlage an Luft und wird zu sogenannten Coils aufgewickelt.

Den schematischen Schnitt durch das erfindungsgemäß korrosionsgeschützte Stahlfeinblech zeigt Fig. 3. Darin stellt 4 eine durch gesteuerte Diffusion entstandene Deckschicht aus einer zinkreichen Zn-Fe-Legierung dar. Durch Analyseverfahren wird eine Dicke der Deckschicht von 1 µm ± 10 % bei einem mittleren Fe-Gehalt von 8 mass% festgestellt. Die verbleibende Zinkschicht 5 mit einer Restdicke von 13...14 µm ist im Rahmen der Analysegenauigkeit eisenfrei.

Das korrosionsgeschützte Stahlfeinblech weist auch bei hohen Verformungsgraden einen sehr geringen Abrieb beim Umformen auf, der demjenigen von feuerverzinkten Feinblechen (Z) entspricht. Rauheit und Gleichmäßigkeit der Oberflächen sowie Punktschweißbarkeit, Phosphatierbarkeit, Lackhaftung und Korrosionsverhalten nach Lackauftrag kommen dagegen den Eigenschaften von ZF (Galvannealed-Feinblech) nahe oder übertreffen diese Eigenschaften. Das Herstellungsverfahren läßt sich im Anschluß an eine Schmelztauchveredelung und mit gleicher Bandgeschwindigkeit durchführen. Es ist damit hochproduktiv und zudem frei von umweltbelastenden Abfallprodukten.

## Patentansprüche

1. Korrosionsgeschütztes Stahlfeinblech, bestehend aus kohlenstoffarmem Stahlfeinblech und einem durch Schmelztauchveredelung oder elektrolytische Abscheidung aufgebrachten zinkhaltigen Überzug mit mindestens 80 mass-% Zink, **dadurch gekennzeichnet, daß** auf dem zinkhaltigen Überzug (2) eine dünne zinkreiche Deckschicht (4) derart aufgebracht ist, **daß** ein oder mehrere Metalle außer Zink oder eine Metallegierung , die kein Zink enthält, durch Vakuumbeschichtung abgeschieden ist und die Deckschicht (4) durch Diffusion und Legierungsbildung an der Oberfläche des zinkhaltigen Überzuges gebildet ist, ohne **daß** an der Grenzfläche zwischen dem Stahlfeinblech (1) und dem zinkhaltigen Überzug (2) eine nennenswerte Diffusion aufgetreten ist.

2. Korrosionsgeschütztes Stahlfeinblech nach Anspruch 1, **dadurch gekennzeichnet, daß** die Dicke der Deckschicht (4) im Bereich zwischen 0.1 µm und 3 µm, vorzugsweise 1 µm liegt.

3. Korrosionsgeschütztes Stahlfeinblech nach Anspruch 1 und 2, **dadurch gekennzeichnet, daß** die Deckschicht (4) aus Zink und mindestens einem der Metalle Eisen, Mangan, Kupfer, Magnesium und Nickel besteht.

4. Korrosionsgeschütztes Stahlfeinblech nach den Ansprüchen 1 bis 3, **dadurch gekennzeichnet, daß** der Zinkgehalt der Deckschicht (4) 80 bis 95 mass-%, vorzugsweise 90 mass-% beträgt.

5. Verfahren zur Herstellung von korrosionsgeschütztem Stahlfeinblech, indem auf kohlenstoffarmem Stahlfeinblech durch Schmelztauchveredelung oder elektrolytische Abscheidung ein zinkhaltiger Überzug mit mindestens 80 mass-% Zink aufgebracht wird, nach Anspruch 1, **dadurch gekennzeichnet, daß** auf das mit dem zinkhaltigen Überzug versehene korrosionsgeschützte Stahlfeinblech ein oder mehrere Metalle außer Zink oder eine Metallegierung, die kein Zink enthält, durch Vakuumbeschichtung aufgebracht wird und anschließend ohne Exposition an oxidierender Atmosphäre in einer Inertgasatmosphäre einer Wärmebehandlung unterworfen wird.

6. Verfahren nach Anspruch 5, **dadurch gekennzeichnet, daß** das oder die Metalle oder die Metallegierung, welche kein Zink enthält, durch Elektronenstrahlbedampfen aufgebracht wird.

7. Verfahren nach Anspruch 5, **dadurch gekennzeichnet, daß** das oder die Metalle oder die Metallegierung, welche kein Zink enthält, durch Magnetron-Sputtern aufgebracht wird.

8. Verfahren nach mindestens einem der Ansprüche 5 bis 7, **dadurch gekennzeichnet, daß** das korrosionsgeschützte Stahlfeinblech vor der Vakuumbeschichtung einer Vakuumvorbehandlung durch lonenbombardement unterworfen wird.

9. Verfahren nach mindestens einem der Ansprüche 5 bis 8, **dadurch gekennzeichnet, daß** das korrosionsgeschützte Stahlfeinblech vor der Vakuumbeschichtung auf eine Temperatur von 150 bis 400°C, vorzugsweise 220°C erwärmt wird.

10. Verfahren nach mindestens einem der Ansprüche 5 bis 9, **dadurch gekennzeichnet, daß** die an die Vakuumbeschichtung anschließende Wärmebehandlung bei einem Inertgasdruck von 10 bis 100 kPa, vorzugsweise 80 kPa, einer Behandlungszeit von maximal 100 s, vorzugsweise jedoch 10 s, bei einer Temperatur im Bereich von 300 bis 400°C durchgeführt wird.

## Claims

1. Steel sheet which is protected against corrosion and comprises a low- carbon steel sheet and a zinc-containing coating, which is applied by hot dip processing or by electrolytic deposition, having at least 80% zinc by mass, **characterised in that** a thin zinc-rich covering layer (4) is applied onto the zinc-containing coating (2) in such a manner that one or more metals apart from zinc or a metal alloy, which contains no zinc, is deposited by means of vacuum coating and the covering layer (4) is formed by diffusion and alloy formation on the surface of the zinc-containing coating without an appreciable diffusion occurring at the interface between the steel sheet (1) and the zinc-containing coating (2).

2. Steel sheet which is protected against corrosion according to claim 1, **characterised in that** the thickness of the covering layer (4) is in the range between 0.1 µm and 3 µm, preferably 1 µm.

3. Steel sheet which is protected against corrosion according to claims 1 and 2, **characterised in that** the covering layer (4) is made of zinc and of at least one of the metals iron, manganese, copper, magnesium and nickel.

4. Steel sheet which is protected against corrosion according to claims 1 to 3, **characterised in that** the zinc content of the covering layer (4) is 80 to 95% by mass, preferably 90% by mass.

5. Method for the production of a steel sheet which is protected against corrosion by applying a zinc-containing covering with at least 80% by mass of zinc onto the low-carbon steel sheet by means of hot dip processing or electrolytic deposition according to claim 1, **characterised in that** one or more metals apart from zinc or a metal alloy, which contains no zinc, is applied onto the steel sheet, which is protected against corrosion and provided with the zinc-containing covering, by means of vacuum coating and then is subjected to a heat treatment in an inert gas atmosphere without exposing to an oxidising atmosphere.

6. Method according to claim 5, **characterised in that** the metal or metals or the metal alloy, which contains no zinc, is applied by means of electron-beam vapour deposition.

7. Method according to claim 5, **characterised in that** the metal or metals or the metal alloy, which contains no zinc, is applied by magnetron sputtering.

8. Method according to at least one of the claims 5 to 7, **characterised in that** the steel sheet which is protected against corrosion is subjected before vacuum coating to a vacuum pretreatment by means of ion bombardment.

9. Method according to at least one of the claims 5 to 8, **characterised in that** the steel sheet which is protected against corrosion is heated before vacuum coating to a temperature of 150 to 400 °C, preferably 220 °C.

10. Method according to at least one of the claims 5 to 9, **characterised in that** the heat treatment subsequent to vacuum coating is implemented at an inert gas pressure of 10 - 100 kPa, preferably 80 kPa, a treatment time of at most 100 s, preferably however 10 s, at a temperature in the range of 300 to 400 °C.

## Revendications

1. Tôle fine d'acier protégée contre la corrosion, comprenant une tôle fine d'acier à faible teneur en carbone et un revêtement contenant du zinc appliqué par passage dans un bain fondu ou par un dépôt électrolytique, contenant au moins 80 % en zinc,
**caractérisée en ce que**
sur le revêtement en zinc (2), on applique une mince couche de couverture (4) riche en zinc, on dépose par revêtement sous vide, un ou plusieurs métaux autre que le zinc ou un alliage de métaux ne contenant pas de zinc, et on forme la couche de revêtement (4) par diffusion et formation d'alliages à la surface du revêtement contenant du zinc, sans qu'il y ait une diffusion significative à la surface limite entre la tôle fine d'acier (1) et le revêtement contenant du zinc (2).

2. Tôle fine d'acier protégée contre la corrosion selon la revendication 1,
**caractérisée en ce que**
l'épaisseur de la couche de revêtement (4) est de l'ordre de 0,1 µm à 3 µm, de préférence de 1 µm.

3. Tôle fine d'acier protégée contre la corrosion selon les revendications 1 et 2,
**caractérisée en ce que**
la couche de revêtement (4) est en zinc et au moins en un des métaux comprenant le fer, le manganèse, le cuivre, le magnésium et le nickel.

4. Tôle fine d'acier protégée contre la corrosion selon l'une quelconque des revendications 1 à 3,
**caractérisée en ce que**
la teneur en zinc de la couche de revêtement (4) est de 80 % à 95 % massique, de préférence 90 % massiques.

5. Procédé de fabrication d'une tôle mince d'acier protégée contre la corrosion selon lequel on applique un revêtement contenant du zinc avec au moins 80 % massique de zinc par traitement par immersion dans un bain de fusion ou dépôt électrolytique, selon la revendication 1,
**caractérisé en ce que**
sur la tôle fine d'acier protégée contre la corrosion, munie d'un revêtement contenant du zinc, on applique par revêtement sous vide un ou plusieurs métaux autres que du zinc ou un alliage de métaux ne contenant pas de zinc et ensuite, sans exposition à une atmosphère oxydante, on soumet à un traitement thermique dans une atmosphère de gaz inerte.

6. Procédé selon la revendication 5,
**caractérisé en ce que**
le ou les métaux ou alliages de métaux ne contenant pas de zinc sont appliqués par évaporation par un faisceau d'électrons.

7. Procédé selon la revendication 5,
**caractérisé en ce que**
le ou les métaux ou alliages de métaux qui ne contiennent pas de zinc sont appliqués par pulvérisation avec un magnétron.

8. Procédé selon l'une quelconque des revendications 5 à 7,
**caractérisé en ce qu'**
on soumet la tôle fine d'acier protégée contre la corrosion, avant d'appliquer le revêtement sous vide à un traitement préalable sous vide par bombardement ionique.

9. Procédé selon l'une quelconque des revendications 5 à 8,
**caractérisé en ce qu'**
avant d'appliquer le revêtement sous vide, on chauffe la tôle fine d'acier protégée contre la corrosion à une température de 150 à 400°C, de préférence de 220°C.

10. Procédé selon l'une quelconque des revendications 5 à 9,
**caractérisé en ce que**
le traitement thermique fait à la suite du revêtement sous vide est effectué à une pression de gaz inerte comprise entre 10 et 100 kPa, de préférence à 80 kPa pendant une durée de traitement maximum de 100s, de préférence toutefois 10s, à une température de l'ordre de 300 à 400°C.
